# EUROPEAN PATENT APPLICATION

(11) **EP 4 425 221 A1**
(43) Date of publication of application: **04.09.2024**
(21) Application number: 23305281.0
(22) Date of filing: 03.03.2023
(51) Int. Cl.: G01V 99/00

(54) **METHODS FOR CALCULATING A VALUE OF A SUBSURFACE PROPERTY**

(71) Applicant: Services Pétroliers Schlumberger, 75007 Paris (FR); Schlumberger Technology B.V., 2514 JG The Hague (NL)
(72) Inventor: BERNARD, Olivier, 34000 Montpellier (FR); DAYNAC, Elodie, 34000 Montpellier (FR); COUTROT, Delphine, 34000 Montpellier (FR); JACOLIN, Jean-Etienne, 34000 Montpellier (FR)
(74) Representative: Schlumberger Intellectual Property Department

(57) **Abstract**

A method of predicting a subsurface property value includes obtaining a plurality of geospatial datapoints; selecting a plurality of modelling areas of the geospatial datapoint, wherein each modelling area overlaps at least a portion of a neighboring modelling area; determining a local model for each modelling area; assigning a local model value for the subsurface property to the local cells based on values of the plurality of geospatial datapoints within the modelling area; determining a global model for the plurality of geospatial datapoints; assigning at least one global model value for the subsurface property to each global cell of the global model; and predicting a calculated value of the subsurface property at a selected location based at least partially on the global model value of a selected global cell of the global model.

## Description

### CROSS-REFERENCE TO RELATED APPLICATIONS

N/A

### BACKGROUND

With geospatial data, when no external constraints interfere, neighboring data have more probability to be closer to each other than distant data. Therefore, global models might not be always relevant. Grouping is done to create groups that are further used to create local models. Depending how this grouping is defined, it will lead to different results. Then, defining local logic might not be true at a global level.

When grouping is done at the large geographic level, the groups are conventionally grouped by lithologies. By considering more local grouping such as a department or a city for instance, the grouping will be done with more precise definition, such as sand, limestone, clay, or other lithology types. This type of effect is known as spatial autocorrelation effect and might lead to biased parameter estimates, meaning the prediction might not be as accurate as expected.

### SUMMARY

In some embodiments, a method of predicting a subsurface property value includes obtaining a plurality of geospatial datapoints and wherein each geospatial datapoint includes at least a location of the geospatial datapoint and a value of a subsurface property; selecting a plurality of modelling areas, wherein each modelling area of the plurality of modelling areas overlaps at least a portion of a neighboring modelling area of the plurality of modelling areas; determining a local model for each modelling area based at least partially on the locations and values of the plurality of geospatial datapoints located in the modelling area, wherein determining the local model includes assigning a local model value for the subsurface property to a plurality of local cells of the local model based on values of the plurality of geospatial datapoints within the modelling area; determining a global model for the plurality of geospatial datapoints, wherein the global model includes a plurality of global cells; assigning at least one global model value for the subsurface property to each global cell of the plurality of global cells based on local model values of the local models overlapping the global cell; and predicting a calculated value of the subsurface property at a selected location based at least partially on the global model value of a selected global cell of the global model.

This summary is provided to introduce a selection of concepts that are further described below in the detailed description. This summary is not intended to identify key or essential features of the claimed subject matter, nor is it intended to be used as an aid in limiting the scope of the claimed subject matter.

Additional features and aspects of embodiments of the disclosure will be set forth in the description which follows, and in part will be obvious from the description, or may be learned by the practice of such embodiments. The features and aspects of such embodiments may be realized and obtained by means of the instruments and combinations particularly pointed out in the appended claims. These and other features will become more fully apparent from the following description and appended claims or may be learned by the practice of such embodiments as set forth hereinafter.

### BRIEF DESCRIPTION OF THE DRAWINGS

In order to describe the manner in which the above-recited and other features of the disclosure can be obtained, a more particular description will be rendered by reference to specific embodiments thereof which are illustrated in the appended drawings. For better understanding, the like elements have been designated by like reference numbers throughout the various accompanying figures. While some of the drawings may be schematic or exaggerated representations of concepts, non-schematic drawings should be considered as being to scale for some embodiments of the present disclosure, but not to scale for other embodiments contemplated herein. Understanding that the drawings depict some example embodiments, the embodiments will be described and explained with additional specificity and detail through the use of the accompanying drawings in which:
FIG. 1 is a schematic diagram of local bias when considering regions of datapoints, according to some embodiments of the present disclosure;
FIG. 2-1 is an array of circular modelling areas, according to some embodiments of the present disclosure;
FIG. 2-2 is a hexagonal ring modeling area, according to some embodiments of the present disclosure;
FIG. 3 is a plurality of overlapping modeling areas including a shared geospatial datapoint, according to some embodiments of the present disclosure;
FIG. 4 is a flowchart illustrating a method of planning a well, according to some embodiments of the present disclosure;
FIG. 5 is a schematic illustration of a method of selecting and validating a local model, according to some embodiments of the present disclosure;
FIG. 6-1 is a schematic illustration of overlapping local models, according to some embodiments of the present disclosure;
FIG. 6-2 is a schematic illustration of combining local models by selection of values, according to some embodiments of the present disclosure;
FIG. 6-3 is a schematic illustration of combining local models by averaging of values, according to some embodiments of the present disclosure;
FIG. 6-4 is a schematic illustration of combining local models by weighted averaging of values, according to some embodiments of the present disclosure;
FIG. 7 is a flowchart illustrating combining local models into a global model, according to some embodiments of the present disclosure;
FIG. 8 illustrates a plurality of modeling areas of different resolutions based on depth information of geospatial datapoints, according to some embodiments of the present disclosure;
FIG. 9 is a flowchart illustrating assigning local model values to a plurality of depth layers, according to some embodiments of the present disclosure;
FIG. 10 is flowchart illustrating creating and combining local model values at a plurality of depth layers of a global model, according to some embodiments of the present disclosure;
FIG. 11-1 is a schematic illustration of selecting discrete depth layers in a dataset, according to some embodiments of the present disclosure;
FIG. 11-2 is a schematic illustration of selecting overlapping depth layers in a dataset, according to some embodiments of the present disclosure;
FIG. 12 is a flowchart illustrating creating a global model with overlapping depth layers, according to some embodiments of the present disclosure; and
FIG. 13 is a representation of subsurface property values along a well trajectory, according to some embodiments of the present disclosure.

### DETAILED DESCRIPTION

Embodiments of the present disclosure generally relate to devices, systems, and methods for predicting a value of a subsurface property. More specifically, embodiments of the present disclosure related to predicting a value of a subsurface property at a selected location based on heterogeneous data for a geographic region. For example, subsurface properties for a geologic formation (soil, sediment, bedrock, etc.) may be available only where wells or other boreholes have been previously drilled and the values for the subsurface properties measured. Because subsurface properties are not easily measured on-demand, datasets are conventionally available only where wells are previously created. The datasets can, therefore, be heterogeneously distributed over a particular geographic region and may be incomplete or inconsistent in the measurements of subsurface values.

In some embodiments, according to the present disclosure, methods for predicting a value of a subsurface property at a selected location include creating a global model from a set of smaller local models that are each created from one or more heterogeneous geospatial datasets. The global model includes a plurality of global cells that are assigned global cell values based on interpolation of measured values of subsurface properties from the heterogeneous geospatial dataset(s). The global model is created by combining overlapping local models to limit and/or prevent local biases in the model creation. In some embodiments, the predicted values can then be used to plan a well, such as selecting a well location, determining a wellbore depth, determining a wellbore location, a thermal recovery of a well at the selected location, or other well planning considerations.

In some embodiments, the geospatial datapoints used to determine the local models and global model include depth information. The depth information can be used to create depth layers to the local models and/or create local models at various depths. For example, the depth layers may be additional layers in a z-direction of a local model with the same boundaries in x- and y-direction. In some examples, the available datapoints at each depth range may be considered independently as separate local models for the associated depth, and these local models may have different boundaries and/or areas in the x- and y-direction.

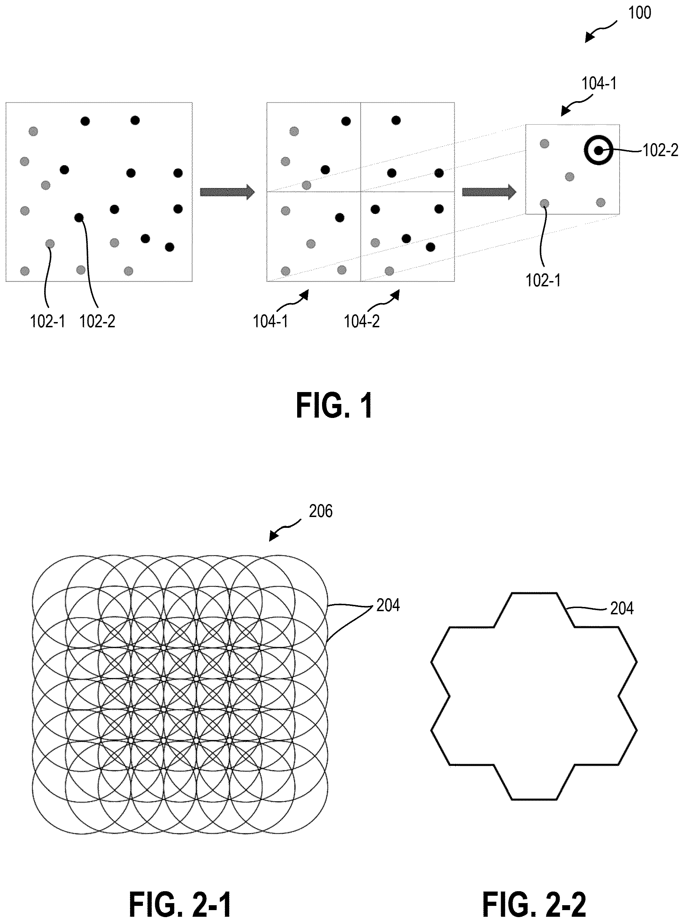

In the process of generating local models, in some embodiments, the geospatial datapoints are divided in smaller parts clusters. In some instances, this clustering is not contextual and biases the resulting models. For example, although an anomaly might be seen in a local context while it is not the case in a more global condition. FIG. 1 illustrates an embodiment of a geospatial dataset 100 with a heterogeneous distribution of geospatial datapoints 102-1, 102-2. The geospatial datapoints 102-1, 102-2 each include at least a location in the x- and y-directions and a value of a subsurface property. In some embodiments, the subsurface property includes thermal transfer rate (e.g., thermal conductivity), porosity, geochemistry or other chemical information, lithology, or other subsurface properties measured during or after the well associated with the geospatial datapoint was created. In some embodiments, as will be described in more detail herein, a geospatial datapoint includes a plurality of values for the subsurface property or value(s) for a plurality of subsurface properties. In some embodiments, as will be described in more detail herein, a geospatial datapoint includes depth information associated with value of the subsurface property and/or a value for the subsurface property at a plurality of depths.

Referring again to FIG. 1, the geospatial dataset 100 is divided into different modelling areas 104-1, 104-2 or subareas within the geospatial dataset 100 that each include a subset of the geospatial datapoints 102-1, 102-2. The geospatial datapoints 102-1, 102-2 may include first geospatial datapoints 102-1 with a first value of a subsurface property and second geospatial datapoints 102-2 with a second value of the subsurface property. In the larger context of the geospatial dataset 100, the first geospatial datapoints 102-1 and the second geospatial datapoints 102-2 are approximately equally represented. However, when the geospatial dataset 100 is divided into a plurality of modelling areas the distribution can be unintentionally and/or undesirable affected, such as in the first modelling area 104-1, which results in the second geospatial datapoint 102-2 appearing to be an anomaly amongst a plurality of first geospatial datapoints 102-1. In conventional statistical modelling, the anomaly may be identified as an error in the data and ignored, producing erroneous local models.

In some embodiments, according to the present disclosure, methods of planning a well generate a global model by creating multiple overlapping local models in overlapping local modelling areas to limit and/or prevent undesirable effects on the underlying dataset. FIG. 2-1 is a schematic representation of an array 206 of modelling areas 204 that each overlap with a plurality of neighbouring modelling areas 204. In some embodiments, the modelling areas 204 are the same shape. In some embodiments, at least two of the modelling areas 204 are different shapes. For example, the modelling areas 204 may be circular, elliptical, rectangular, triangular, pentagonal, octagonal, hexagonal, other regular polygonal shapes, regular curved shapes, irregular polygonal or curved shapes, or combinations thereof. In some embodiments, the modelling areas 204 are the same size, irrespective of shape. For example, the modelling areas may have the same area. In other examples, the modelling areas may have an equal size in at least one dimension, such as an x-direction, a y-direction, a latitude, a longitude, a diameter, or another direction. In some embodiments, at least two of the modelling areas have a different size. FIG. 2-2 illustrates an example of a hexagonal ring modelling area 204 that may allow for consistent size and shape overlapping regions between modelling areas.

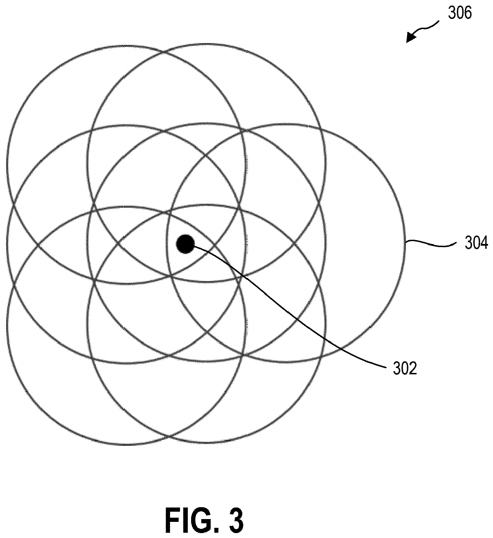

FIG. 3 illustrates an array 306 of modelling areas 304 that all include a geospatial datapoint 302. In FIG. 3, seven modelling areas 304 are shown overlapping one another and including the same geospatial datapoint 302, but it should be understood that any number of modelling areas 304 may include a shared geospatial datapoint. By dividing a dataset or plurality of datasets into overlapping modelling areas, a method, according to some embodiments of the present disclosure, provides overlapping local models that can be combined into a global model that reduces errors and provides reliable determinations of one or more values of subsurface properties for well planning.

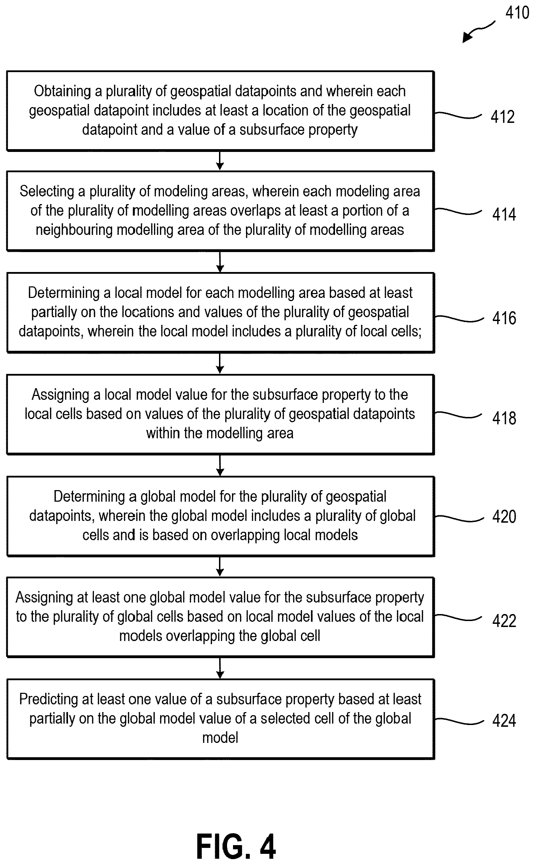

FIG. 4 is a flowchart illustrating an embodiment of a method 410 for predicting a value of a subsurface property. In some embodiments, the calculated values of the subsurface property are used to plan a well or wellbore. For example, the calculated values of the subsurface property may be used to plan a geothermal well, such as selecting a wellhead location, a quantity of wellbores, an orientation of a wellbore, a length of a wellbore, a total length of wellbores of a well, a thermal recovery capacity of the wellbores and/or well, etc. For example, the calculated values of the subsurface property may be used to plan a hydrological well, such as selecting a wellhead location, an orientation of a wellbore, a length of a wellbore, a total length of wellbores of a well, a water recovery capacity of the wellbores and/or well, etc. In some embodiments, the calculated values of the subsurface property are used to determine the feasibility of planning a geothermal well at a selected location.

In some embodiments, the method 410 includes obtaining a plurality of geospatial datapoints at 412. Each geospatial datapoint includes at least a location of the geospatial datapoint and a value of a subsurface property. As described herein, the subsurface property may be any continuous or discrete subsurface property. A continuous subsurface property is a property for which measured values are continuous values, such as temperature, thermal transfer rate, porosity, etc. A discrete subsurface property is a property for which a measured value defines one of a plurality of values, such as lithology (e.g., clay, sand, hard rock). In some embodiments, the subsurface property includes both a discrete component and a continuous component, such as geochemical properties in which the geochemistry identifies a mineral composition with elemental ranges for one or more components of the mineral. For example, some minerals have binary ternary replacements for some elements within the chemical structure. In such examples, a discrete value may be the mineral endmember, such as Albite for plagioclase, and a continuous value may be the sodium (relative to calcium solid solution) composition of the plagioclase.

In some embodiments, obtaining the plurality of geospatial datapoints includes obtaining geospatial datapoints from a plurality of sources and/or datasets. In some embodiments, obtaining the plurality of geospatial datapoints includes accessing public databases that may include erroneous or unverified geospatial datapoints. In such instances, the overlapping modelling areas described herein provide additional identification and verification of the location and/or values of the subsurface property of the geospatial datapoints.

The method 410 further includes selecting a plurality of modelling areas, wherein each modelling area of the plurality of modelling areas overlaps at least a portion of a neighbouring modelling area of the plurality of modelling areas at 414. In some embodiments, the modelling areas are the same shape. In some embodiments, at least two of the modelling areas are different shapes. For example, the modelling areas may be circular, elliptical, rectangular, triangular, pentagonal, octagonal, hexagonal, other regular polygonal shapes, regular curved shapes, irregular polygonal or curved shapes, or combinations thereof. In at least one embodiment, a modelling area is a hexagonal ring. In some embodiments, the modelling areas are the same size, irrespective of shape. For example, the modelling areas may have the same area. In other examples, the modelling areas may have an equal size in at least one dimension, such as an x-direction, a y-direction, a latitude, a longitude, a diameter, or another direction. In some embodiments, at least two of the modelling areas have a different size. In some embodiments, an overlapping region between neighbouring modelling areas is constant through the plurality of modelling areas. In some embodiments, the overlapping regions between neighbouring modelling areas varies through the plurality of modelling areas.

In some embodiments, the size and/or shape of the modelling areas is selected based at least partially on external constraints. For example, known discontinuities in the subsurface property of interest or other subsurface properties may provide one or more boundaries to a modelling area. In at least one example, a region has a known change in geologic formation and at least one modelling area is selected based on the boundary between geologic formations. In a particular example, a thermal transfer rate is known to change with lithology and a modelling area is the selected based at least partially on known lithology boundary.

The method 410 further includes determining a local model for each modelling area based at least partially on the locations and values of the plurality of geospatial datapoints of the modelling area at 416, wherein the local model includes a plurality of cells. The local model provides a value of the subsurface property for each location within the modelling area. In some embodiments, determining the local model includes assigning local model values for the subsurface property to the local cells based on the values of the plurality of geospatial datapoints within the modelling area at 418. Assigning local model values may include using a statistical model or machine learning model to interpolate values between input geospatial datapoints. A statistical model may be any algorithm or other mathematical model that receives inputs to calculate values for subsurface properties.

A same location may then be part of a first local cell of a first local model associated with a first modelling area and a second local cell of a second local model associated with a second modelling area, etc. The values of the subsurface properties for the modelling area may be different depending on the local model that is applied.

In some embodiments, a first local cell of a first local model associated to a first modelling area, and a second local cell of a second local model associated to a second modelling area, etc. may have the same boundaries. The value of the subsurface property for the first local cell and second local cell may however be different based upon the determinations of the first local model and the second local model.

In some embodiments, a cell is a geographic region of a fixed area that is tiled with other cells to cover the local model or global model. For example, the cell may be a square region of the local model or global model. In some examples, the cell is a hexagonal region. In at least one example, the cell is a differential area that allows for the local model or global model to be substantially continuous across the area of the local model or global model. For example, a cell of differential area may be interpreted as a point value in the local model or global model.

As used herein, a "machine learning model" refers to a computer algorithm or model (e.g., a classification model, a regression model, a language model, an object detection model) that can be tuned (e.g., trained) based on training input to approximate unknown functions. For example, a machine learning model may refer to a neural network or other machine learning algorithm or architecture that learns and approximates complex functions and generate outputs based on a plurality of inputs provided to the machine learning model. In some embodiments, a machine learning system, model, or neural network described herein is an artificial neural network. In some embodiments, a machine learning system, model, or neural network described herein is a convolutional neural network. In some embodiments, a machine learning system, model, or neural network described herein is a recurrent neural network. In at least one embodiment, a machine learning system, model, or neural network described herein is a Bayes classifier. As used herein, a "machine learning system" may refer to one or multiple machine learning models that cooperatively generate one or more outputs based on corresponding inputs. For example, a machine learning system may refer to any system architecture having multiple discrete machine learning components that consider different kinds of information or inputs.

As used herein, an "instance" refers to an input object that may be provided as an input to a machine learning system to use in generating an output, such as a value of a subsurface property of a known geospatial datapoint. For example, an instance may refer to any known geospatial datapoint within a modelling area. In some embodiments, the machine learning system has a plurality of layers with an input layer configured to receive at least one input training dataset or input training instance and an output layer, with a plurality of additional or hidden layers therebetween. The training datasets can be input into the machine learning system to train the machine learning system and identify values of subsurface properties, associated subsurface properties, locations of discrete or continuous values for subsurface properties, or other attributes of the training instances that allow the microcontroller to identify relevant or accurate values of subsurface properties within a given modelling area. In some embodiments, the machine learning system can receive multiple training datasets concurrently and learn from the different training datasets simultaneously.

In some embodiments, the machine learning system includes a plurality of machine learning models that operate together. Each of the machine learning models has a plurality of hidden layers between the input layer and the output layer. The hidden layers have a plurality of input nodes, where each of the nodes operates on the received inputs from the previous layer. In a specific example, a first hidden layer has a plurality of nodes and each of the nodes performs an operation on each instance from the input layer. Each node of the first hidden layer provides a new input into each node of the second hidden layer, which, in turn, performs a new operation on each of those inputs. The nodes of the second hidden layer then passes outputs, such as identified clusters, to the output layer.

In some embodiments, each of the nodes has a linear function and an activation function. The linear function may attempt to optimize or approximate a solution with a line of best fit. The activation function operates as a test to check the validity of the linear function. In some embodiments, the activation function produces a binary output that determines whether the output of the linear function is passed to the next layer of the machine learning model. In this way, the machine learning system can limit and/or prevent the propagation of poor fits to the data and/or non-convergent solutions.

The machine learning model includes an input layer that receives at least one training dataset. In some embodiments, at least one machine learning model uses supervised training. In some embodiments, at least one machine learning model uses unsupervised training. Unsupervised training can be used to draw inferences and find patterns or associations from the training dataset(s) without known outputs. In some embodiments, unsupervised learning can identify clusters of similar labels or characteristics for a variety of training instances and allow the machine learning system to extrapolate the performance of instances with similar characteristics.

In some embodiments, semi-supervised learning can combine benefits from supervised learning and unsupervised learning. As described herein, the machine learning system can identify associated labels or characteristics (such as location or values for subsurface properties) between instances, which may allow a training dataset with known outputs and a second training dataset including more general input information to be fused. Unsupervised training can allow the machine learning system to cluster the instances from the second training dataset without known outputs and associate the clusters with known outputs from the first training dataset.

The method 410, in some embodiments, includes determining a global model for the plurality of geospatial datapoints at 420, wherein the global model includes a plurality of global cells based on local model values of the overlapping local models. In some embodiments, the global cells are the same as the local model cells. In some embodiments, the global cells have the same shape, size, location, or combinations thereof as the local model cells. The global model includes values for the subsurface property of interest by assigning a global model value for the subsurface property to the plurality of global cells based on local model values of the local models overlapping the global cell at 422. As will be described herein, the global model value is determined at least partially based on the local model values at the location of a global cell. In some embodiments, the global cell overlaps at least one local cell, and the global model value of the global cell is based at least partially on the local model value of the at least one local cell. For example, the global model value may be determined by selecting one of the local model values at the location of the global cell. In another example, the global model value may be determined by merging the local model values at the location of the global cell. Merging the local model values may include averaging the local model values or averaging the local model values based on a weighted average of the local model values.

The method 410 further includes predicting at least one value of a subsurface property at a location in the global model based at least partially on the global model value of the selected global cell of the global model at 424. For example, the global model value of the subsurface property may reflect a desired property (e.g., thermal transfer rate of a planned geothermal well), and the global model value may predict the desired property at the planned well location. In other examples, the global model value of the subsurface property may reflect an undesired property (e.g., an undesirable lithology) of a planned well or other borehole, and a planner may avoid such a location. In other examples, some anomalies within a global model may be detected and may help to discard wrong or unverified data.

As described herein, in some embodiments, the predicted values of the subsurface property are used to plan a well or wellbore. For example, the predicted values of the subsurface property may be used to plan a geothermal well, such as selecting a wellhead location, a quantity of wellbores, an orientation of a wellbore, a length of a wellbore, a total length of wellbores of a well, a thermal recovery capacity of the wellbores and/or well, etc. For example, the predicted values of the subsurface property may be used to plan a hydrological well, such as selecting a wellhead location, an orientation of a wellbore, a length of a wellbore, a total length of wellbores of a well, a water recovery capacity of the wellbores and/or well, etc.

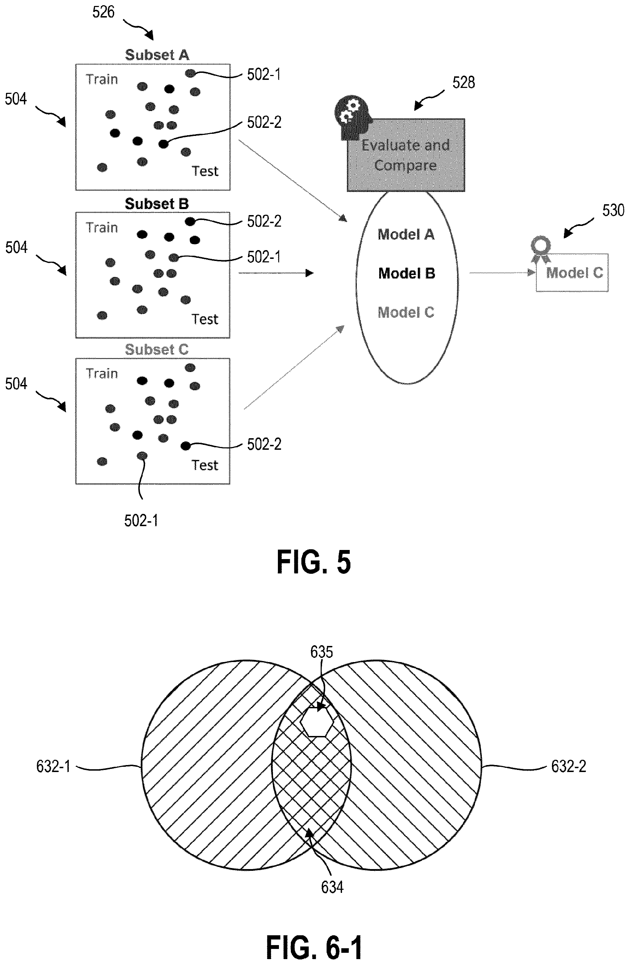

In some embodiments, a method, according to the present disclosure, further includes selecting the local model for a modelling area from a plurality of potential local models. In such embodiments, a plurality of datasets may be used to assign values of the subsurface property to the local cells of the modelling area, each dataset including a distinct set of geospatial datapoints of the modelling area. Each of the potential local models results from the application of a predetermined statistical model to a dataset from the plurality of datasets. Selecting the local model among the plurality of local models may include a testing and/or validation of the potential local model values that are calculated by the local model. For example, FIG. 5 is a flowchart that schematically illustrates a method of selecting a local model among the plurality of potential local models using the input dataset of geospatial datapoints.

In some embodiments, the method includes designating at 526 a first portion of the geospatial datapoints in the modelling area 504 as training geospatial datapoints 502-1 (i.e., a first set of training datapoints) and a second portion of the geospatial datapoints in the modelling area 504 as test geospatial datapoints 502-2. In some embodiments, no less than 70% of the geospatial datapoints are training geospatial datapoints 502-1 and the remaining geospatial datapoints are test geospatial datapoints 502-2. In some embodiments, no less than 80% of the geospatial datapoints are training geospatial datapoints 502-1 and the remaining geospatial datapoints are test geospatial datapoints 502-2. In some embodiments, no less than 90% of the geospatial datapoints are training geospatial datapoints 502-1 and the remaining geospatial datapoints are test geospatial datapoints 502-2.

The method then repeats randomly dividing the dataset of geospatial datapoints in the modelling area 504 into training geospatial datapoints 502-1 and test geospatial datapoints 502-2 a predetermined number of times (e.g., creating a second set of training geospatial datapoints, a third set of geospatial datapoints, etc.) and inputting each set of training geospatial datapoints 502-1 into a statistical model or machine learning model to create an associated local model based on each iteration of the training geospatial datapoints 502-1. Each local model based on each iteration of the training geospatial datapoints 502-1 is scored at 528 by comparing the calculated values for locations of the test geospatial datapoints 502-2 against the known values of the test geospatial datapoints 502-2 for each associated potential local model. After calculating a validation score for each local model for the dataset of geospatial datapoints, the method includes selecting the local model as being the potential local model with the best validation score at 530.

In some embodiments, inputting at least a set of training geospatial datapoints 502-1 into a statistical model or machine learning model to create an associated local model based on each iteration of the training geospatial datapoints 502-1 includes inputting the at least one set of training geospatial datapoints 502-1 into a plurality of different statistical models or machine learning models to create an associated local model based on each of the plurality of the statistical model or machine learning models. Examples of statistical models may include kriging, such as ordinary kriging or universal kriging, using a plurality of variograms (such as gaussian or spherical), or a clustering model, etc. but any statistical or machine learning model may be used in the current disclosure. The local models produced via different training geospatial datapoints and/or different models may be scored at 528 to produce a validation score, and after producing the validation score, the method may include selecting the best local model at 530.

In some embodiments, the validation score includes one or more of a median error value, a selected percentile error value (e.g., an 80^{th} percentile error value), a standard deviation, a nominal error value, or other validations of the quality of the model. In some embodiments, selecting the best local model includes selecting the local model with the lowest median error value. In some embodiments, the validation score is based on a weighted average or combination of one or more of the foregoing. For example, a validation score may be based on both a median error value and a standard deviation. In some examples, the validation score may be based on an equal weighting of the median error value and the standard deviation, while in other examples, the validation score may be based more heavily on the median error value than the standard deviation.

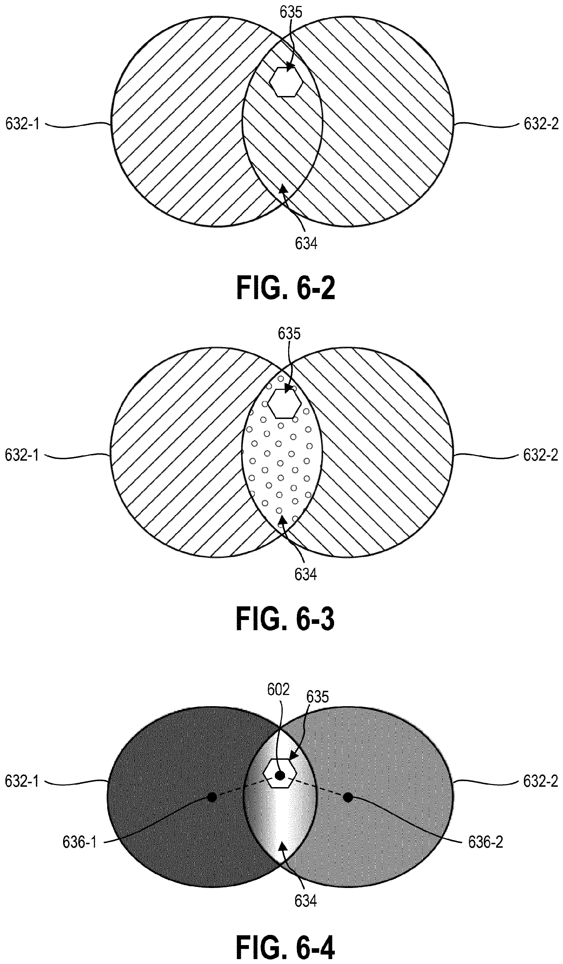

FIG. 6-1 through FIG. 6-4 illustrates different methods of combining values of subsurface properties where a plurality of local models overlaps a global cell of a global model overlapping local models. As described above, after assigning local model values to local cells using the local models, methods, according to the present disclosure, include combining the local model values in overlapping regions of neighbouring local models (and the modelling areas associated therewith) of subsurface properties where a plurality of local models overlap to build toward a global model. Combining local models and assigning values to the global cell(s) at the overlapping regions can include a variety of mechanisms.

FIG. 6-1 schematically illustrates an embodiment of a first local model 632-1 and a neighbouring second local model 632-2. The first modelling area of the first local model 632-1 and the second modelling area of the second local model 632-2 overlap in an overlapping region 634. In some embodiments, the overlapping region 634 includes one or more global cells 635 that overlap local cells from each of the first local model 632-1 and the second local model 632-2. In some embodiments, calculated values for local cells within the overlapping region 634 are different for the first local model 632-1 and the second local model 632-2. To combine the values of the first local model 632-1 and the second local model 632-2 in the global cell(s) 635 of the overlapping region, different methods can be used and/or validated against one another.

FIG. 6-2 illustrates an embodiment of a first local model 632-1 and a second local model 632-2 combined in an overlapping region 634 by selecting and assigning global model values for the global cell(s) 635 situated in the overlapping region 634. In some embodiments, combining the local model values of the overlapping region 634 includes selecting one global model value to use for all global cells situated in the overlapping region 634, such as illustrated in FIG. 6-2. In some embodiments, the local model with the higher resolution (i.e., smaller modelling area size) is selected, as a higher resolution may be correlated with lower variation in the values of the datapoints therein. In some embodiments, the local model with the greater quantity of input geospatial datapoints is selected, as a local model with more input or training geospatial datapoints may be more accurate. In some embodiments, the local model with higher validation score from a prior validation is selected, as a local model with a higher validation score may be more accurate. The validation score may be calculated as described above for better local model selection for a modelling area. In some embodiments, the validation score is calculated for the local models associated to different modelling areas overlapping with the global cell(s).

In some embodiments, combining the local model values of the overlapping region 634 includes selecting global model values for individual global cells in the overlapping region 634. In some embodiments, selecting global model values for individual global cells includes comparing the local model values to known values of geospatial data points in the overlapping region 634. For example, the first local model 632-1 and second local model 632-2 may share a known geospatial datapoint in the overlapping region 634, and the calculated local model values for each of the first local model 632-1 and second local model 632-2 proximate the known geospatial datapoint may be compared to the value of the known geospatial datapoint, where the closer value of the local model values is selected for the global model value.

In some embodiments, combining the local model values of the overlapping region 634 includes merging the local model values of a first local model 632-1 and the local model values of a second local model 632-2 in the overlapping region 634, such as illustrated in FIG. 6-3. In some embodiments, merging the local model values includes averaging the local model values for each global cell 635 in the overlapping region 634. In some embodiments, a weighted average of local model values provides a more accurate representation of the local model values.

FIG. 6-4 illustrates an embodiment of a first local model 632-1 and a second local model 632-2 combined in an overlapping region 634 by merging values of the cells of the overlapping region 634 by weighted averaging. In some embodiments, the weighting of the averages of the local model values is based at least partially on a proximity to a centerpoint 636-1, 636-2 of each local model 632-1, 632-2, respectively. For example, the portions of the overlapping region 634 closer to the first centerpoint 636-1 of the first local model 632-1 are closer in value to the local model values of the first local model 632-1, and the portions of the overlapping region 634 closer to the second centerpoint 636-2 of the second local model 632-2 are closer in value to the local model values of the second local model 632-2. In a particular example, a geospatial datapoint 602 or global cell 635 that is equidistant from the first centerpoint 636-1 and the second centerpoint 636-2 receives equal weighting in averaging the value from the first local model 632-1 and the second local model 632-2. In some embodiments, the weighting of the averages of the local model values is based at least partially on relative validation score of the first local model 632-1 and the second local model 632-2. For example, a better validation score for the first local model 632-1 may result in a weighted average that emphasizes the local model values of the first local model 632-1. In some embodiments, the weighting of the averages of the local model values is based at least partially on relative modelling area size of the first local model 632-1 and the second local model 632-2. For example, a smaller modelling area size for the first local model 632-1 may result in a weighted average that emphasizes the local model values of the first local model 632-1. In some embodiments, combining the local model values of the overlapping region 634 includes selecting values for at least a first portion of the overlapping region 634 and merging values for at least a second portion of the overlapping region 634.

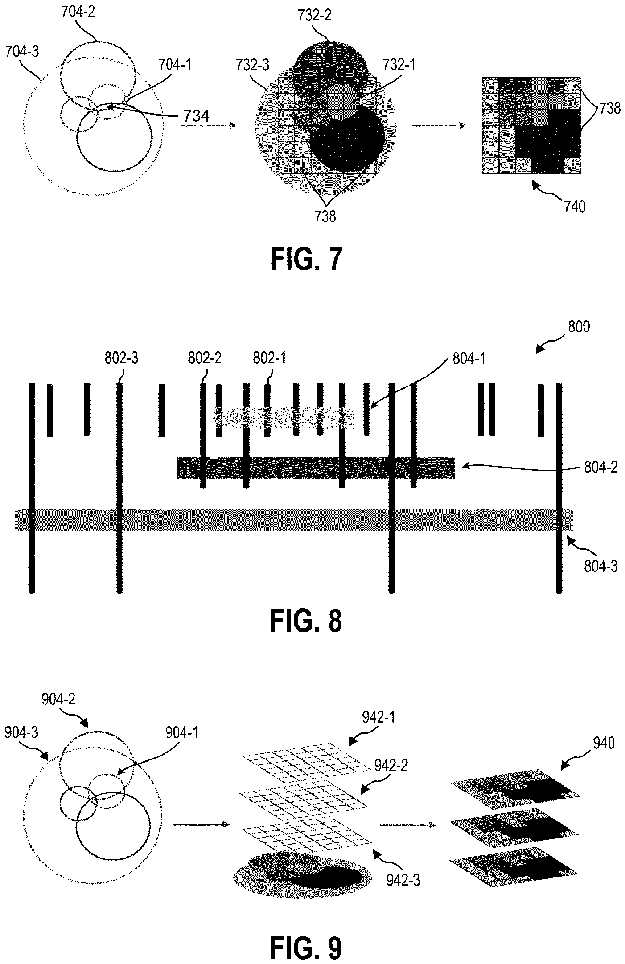

FIG. 7 is a flowchart illustrating an embodiment of combining a plurality of local models to create a global model. While FIG. 6-1 to 6-4 focus on assignment of local model values to one global cell of the global model, FIG. 7 shows assignment of values to a plurality of global cells of the global model. A plurality of modelling areas 704-1, 704-2, 704-3 are selected, where the modelling areas 704-1, 704-2, 704-3 define a plurality of overlapping regions 734. In some embodiments, the modelling areas 704-1, 704-2, 704-3 have different sizes, such as the first modelling area 704-1 being smaller (and higher resolution) than a second modelling area 704-2, and the second modelling area 704-2 being smaller (and higher resolution) than a third modelling area 704-3. The local models 732-1, 732-2, 732-3 are generated for the modelling areas 704-1, 704-2, 704-3, and values are assigned to cells 738 in at least the overlapping regions 734. In the illustrated example, the values of the cells 738 in the overlapping regions 734 are selected from the local model 732-1, 732-2, 732-3 with the smaller size and/or higher resolution. The global model 740 of cells 738 is, therefore, assigned values based local model values with the highest resolution available according to the modelling areas defined as inputs to the statistical model or machine learning model. However, any of the methods described hereinabove in relationship with FIG. 6-1 to 6-4 may be used to assign a local model value to each global cells of the global models.

While modelling areas and local models have been defined in relation to x- and y-directions, it should be understood that the geospatial datapoints and the local models created therefrom may include depth information. Referring now to FIG. 8, an embodiment of a dataset 800 includes a plurality of geospatial datapoints 802-1, 802-2, 802-3 wherein at least some of the geospatial datapoints 802-1, 802-2, 802-3 include depth information associated with the values of a subsurface property. For example, a third geospatial datapoint 802-3 has a greater depth than a second geospatial datapoint 802-2, and the second geospatial datapoint 802-2 has a greater depth than a first geospatial datapoint 802-1. In some embodiments, modelling areas 804-1, 804-2, 804-3 may be selected for each range of depths. For example, values at deep measurements, such as that associated with the third geospatial datapoint 802-3 may be less common than a value at a shallow measurement, such as associated with the first geospatial datapoint 802-1. A model may then be optimized by using different modelling areas at different depths. For instance, a first modelling area 804-1 selected at a shallow depth associated with the first geospatial datapoint 802-1, therefore, may include more geospatial datapoints and be of higher resolution than a second modelling area 804-2 selected at an intermediate depth associated with the second geospatial datapoint 802-2 or a third modelling area 804-3 selected at a greater depth associated with the third geospatial datapoint 802-3.

FIG. 9 schematically illustrates a plurality of modelling areas 904-1, 904-2, 904-3 used to create local models, similar to as described above. In some embodiments, global model values can be assigned to cells of depth layers 942-1, 942-2, 942-3 of a global model 940 in a vertical or z-direction of the global model 940. In such an embodiment, the combination of the local models results in a three-dimensional grid with a plurality of depth layers 942-1, 942-2, 942-3 that assume equal values for the subsurface property at a range of depths. The local models are consolidated as described above and can be illustrated as in FIG. 9. In FIG. 9, as there is no depth information to the local models, the combination of the local models provides the same results for all the depth layers 942-1, 942-2, 942-3 of the vertical axis.

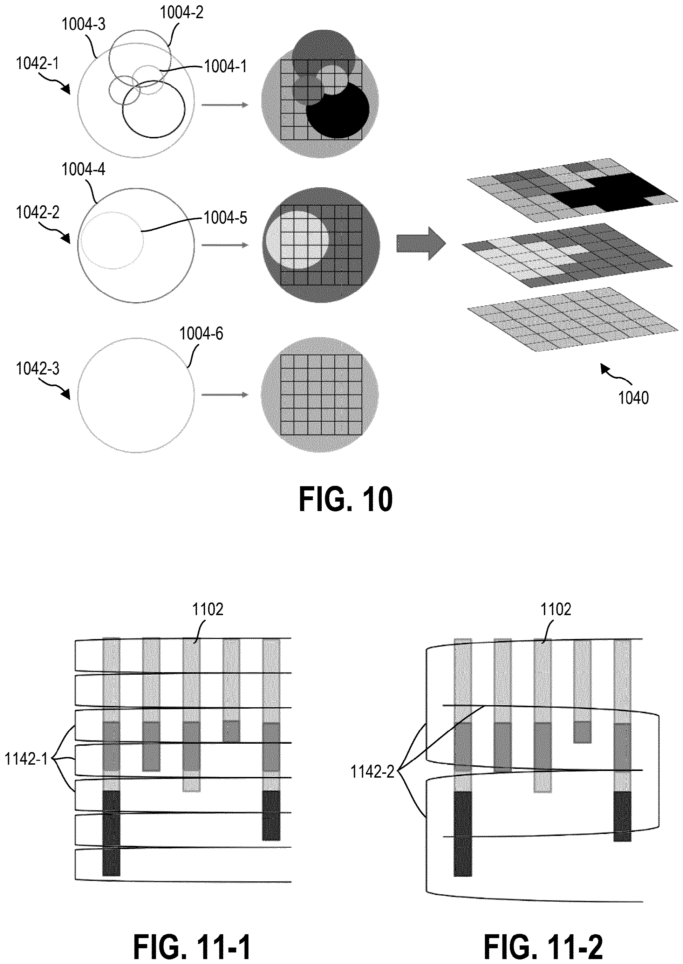

When the geospatial datapoints include depth information, local models may be created for each depth layer based on the depth information, such as described in relation to FIG. 8. In some embodiments, the method uses resolutions for each depth layer and/or local model of the depth layer based at least partially on data heterogeneity of the geospatial datapoints in the z-direction. In this case, each depth layer may be calculated as described herein with the selection of modelling areas, the creation of local models, and the combination of overlapping local models. However, any combination method described hereinabove for combining local model cells may be used to assign the local model values to each global cell of the global model grid. The consolidation of the local models is performed on each depth layer, and the global model 1040 is represented as a three-dimensional grid, as illustrated in the embodiment of FIG. 10.

FIG. 10 illustrates an embodiment of three depth layers 1042-1, 1042-2, 1042-3 that each have different modelling areas (1004-1, 1004-2, 1004-3 in the first depth layer 1042-1; 1004-4, 1004-5 in the second depth layer 1042-2; 1004-6 in the third depth layer 1042-3) based at least partially on the density of geospatial datapoints at the associated depth of the depth layer. The modelling areas and geospatial datapoints therein are used to create local models for each depth layer, which are then combined to into cells, as described herein, of discrete depth layers of the global model 1040.

In some embodiments, the depth layers are defined by discrete boundaries between the layers, wherein the values or ranges of values in depth layers do not overlap. In some embodiments, the depth layers are defined with an overlap between the depth layers in the z-direction, as well. FIG. 11-1 illustrates a plurality of depth layers 1142-1 created by partitioning the geospatial datapoints 1102 at discrete, non-overlapping depth ranges such as described in relation to FIG. 10. FIG. 11-2 illustrates a plurality of depth layers 1142-2 created by partitioning the geospatial datapoints 1102 at overlapping depth ranges. In overlapping the depth ranges of the depth layers 1142-2, in some embodiments, the values of the subsurface properties are combined to create sublayers in the depth information.

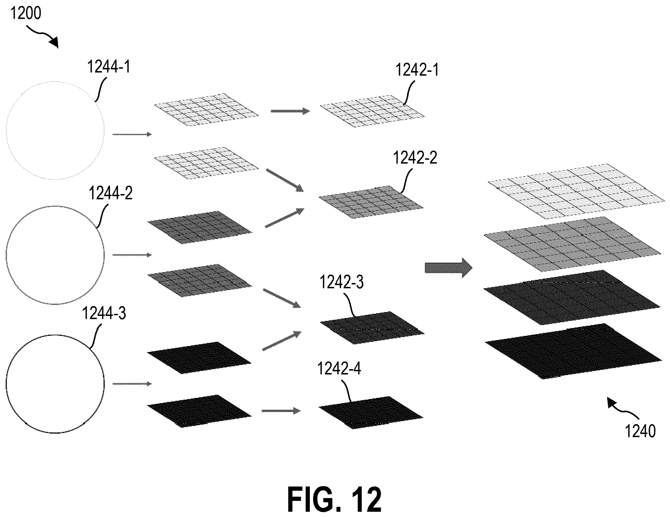

FIG. 12 illustrates the creation of a model 1240 including depth layers. The input dataset 1200 includes values collected at three depths 1244-1, 1244-2, 1244-3 of the geospatial datapoints. In some embodiments, the dataset is divided into depth layers by overlapping depth ranges and averaging the values of the subsurface property, such as described in FIG. 11-2. The values of the subsurface property measured at three depths, in some embodiments, create four depth layers including a top depth layer 1242-1 having subsurface property values substantially equal to the first depth 1244-1, a first overlapped depth layer 1242-2 having subsurface property values based upon the subsurface property values measured at the first depth 1244-1 and the second depth 1244-2, a second overlapped depth layer 1242-3 having subsurface property values based upon the subsurface property values measured at the second depth 1244-2 and the third depth 1244-3, and a bottom depth layer 1242-4 having subsurface property values substantially equal to the third depth 1244-3. In at least some embodiments, the overlapping depth layers 1242-2, 1242-3 allow for an improved resolution in the vertical direction for some datasets 1200. In some embodiments, the sublayers can allow an input dataset 1200 to have depth layers with subsurface property values at equal depths (or substantially equal depths) to a neighboring, overlapping modelling area or local model.

The depth information of the datasets can allow for the prediction and/or visualization of a value of a subsurface property along a well trajectory. For example, the subsurface property value may be predicted and/or visualized based at least partially on local models associated with two neighboring modeling areas having equal depth ranges. In some examples, the subsurface property value may be predicted and/or visualized based at least partially on local models associated with two neighboring modeling areas having different depth ranges. In at least one embodiment, a method includes creating one or more sublayers of a first local model wherein at least one of the one or more sublayers has a depth or depth range substantially equal to a depth of the second local model.

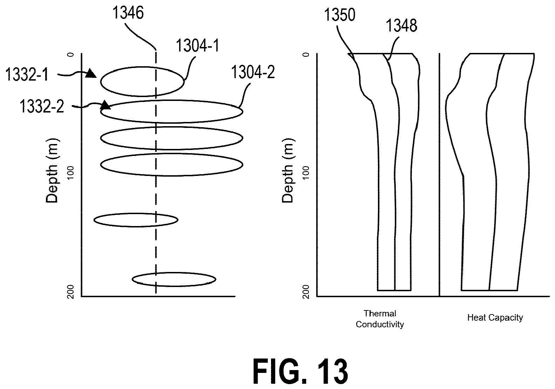

FIG. 13 illustrates an embodiment of a visualization software depicting values of subsurface properties along a potential well trajectory (e.g., a geospatial location) based on local models associated with modelling areas having different depth ranges. For example, the first local model 1332-1 is derived from a first modelling area 1304-1 at a first depth range. The second local model 1332-2 is derived from a second modelling area 1304-2 at a second depth range. The well trajectory 1346 passes through local cells of both of the first local model 1332-1 and the second local model 1332-2, and the visualization 1348 presents the predicted values along the potential well trajectory 1346 (including values associated with additional local models at additional depth ranges). In some embodiments, the visualization includes an average predicted value 1348 for the subsurface property along the potential well trajectory. In some embodiments, visualization includes a range of predicted values, such as an 80^{th} percentile range 1350, for the subsurface property along the potential well trajectory.

In some embodiments, determining the local model and assigning a local model value for the subsurface property to local model cells is performed according to any of the methods described herein. For example, the local models may be determined, selected, and validated such as described in relation to FIG. 4 and FIG. 5. In some embodiments, depth layers of an input dataset are created such as described in relation to FIG. 11-1 and 11-2. In some embodiments, additional sublayers are created from values at different depths, such as described in relation to FIG. 12.

### INDUSTRIAL APPLICABILITY

Embodiments of the present disclosure generally relate to devices, systems, and methods for predicting a value of a subsurface property. More specifically, embodiments of the present disclosure related to predicting a value of a subsurface property at a selected location based on heterogeneous data for a geographic region. For example, subsurface properties for a geologic formation (soil, sediment, bedrock, etc.) may be available only where wells or other boreholes have been previously drilled and the values for the subsurface properties measured. Because subsurface properties are not easily measured on-demand, datasets are conventionally available only where wells are previously created. The datasets can, therefore, be heterogeneously distributed over a particular geographic region and may be incomplete or inconsistent in the measurements of subsurface values.

In some embodiments, according to the present disclosure, methods for predicting a value of a subsurface property at a selected location include creating a global model from a set of smaller local models that are each created from one or more heterogeneous geospatial datasets. The global model includes a plurality of global cells that are assigned global cell values based on interpolation of measured values of subsurface properties from the heterogeneous geospatial dataset(s). The global model is created by combining overlapping local models to limit and/or prevent local biases in the model creation. In some embodiments, the predicted values can then be used to plan a well, such as selecting a well location, determining a wellbore depth, determining a wellbore location, a thermal recovery of a well at the selected location, or other well planning considerations.

In some embodiments, the geospatial datapoints used to determine the local models and global model include depth information. The depth information can be used to create depth layers to the local models and/or create local models at various depths. For example, the depth layers may be additional layers in a z-direction of a local model with the same boundaries in x- and y-direction. In some examples, the available datapoints at each depth range may be considered independently as separate local models for the associated depth, and these local models may have different boundaries and/or areas in the x- and y-direction.

In the process of generating local models, in some embodiments, the geospatial datapoints are divided in smaller parts clusters. In some instances, this clustering is not contextual and biases the resulting models. For example, although an anomaly might be seen in a local context while it is not the case in a more global condition. In some embodiments, a geospatial dataset has a heterogeneous distribution of geospatial datapoints. The geospatial datapoints may each include at least a location in the x- and y-directions and a value of a subsurface property. In some embodiments, the subsurface property includes thermal transfer rate (e.g., thermal conductivity), porosity, geochemistry or other chemical information, lithology, or other subsurface properties measured during or after the well associated with the geospatial datapoint was created. In some embodiments, as will be described in more detail herein, a geospatial datapoint includes a plurality of values for the subsurface property or value(s) for a plurality of subsurface properties. In some embodiments, as will be described in more detail herein, a geospatial datapoint includes depth information associated with value of the subsurface property and/or a value for the subsurface property at a plurality of depths.

In some embodiments, the geospatial dataset is divided into different modelling areas or subareas within the geospatial dataset that each include a subset of the geospatial datapoints. The geospatial datapoints may include first geospatial datapoints with a first value of a subsurface property and second geospatial datapoints with a second value of the subsurface property. In the larger context of the geospatial dataset, the first geospatial datapoints and the second geospatial datapoints are approximately equally represented. However, when the geospatial dataset is divided into a plurality of modelling areas the distribution can be unintentionally and/or undesirable affected, such as in the first modelling area, which results in the second geospatial datapoint appearing to be an anomaly amongst a plurality of first geospatial datapoints. In conventional statistical modelling, the anomaly may be identified as an error in the data and ignored, producing erroneous local models.

In some embodiments, according to the present disclosure, methods of planning a well generate a global model by creating multiple overlapping local models in overlapping local modelling areas to limit and/or prevent undesirable effects on the underlying dataset. In some embodiments, an array of modelling areas each overlap with a plurality of neighbouring modelling areas. In some embodiments, the modelling areas are the same shape. In some embodiments, at least two of the modelling areas are different shapes. For example, the modelling areas may be circular, elliptical, rectangular, triangular, pentagonal, octagonal, hexagonal, other regular polygonal shapes, regular curved shapes, irregular polygonal or curved shapes, or combinations thereof. In some embodiments, the modelling areas are the same size, irrespective of shape. For example, the modelling areas may have the same area. In other examples, the modelling areas may have an equal size in at least one dimension, such as an x-direction, a y-direction, a latitude, a longitude, a diameter, or another direction. In some embodiments, at least two of the modelling areas have a different size.

In some embodiments, an array of modelling areas all includes a geospatial datapoint in each modelling area. In some examples, seven modelling areas overlapping one another and include the same geospatial datapoint. It should be understood that any number of modelling areas may include a shared geospatial datapoint. By dividing a dataset or plurality of datasets into overlapping modelling areas, a method, according to some embodiments of the present disclosure, provides overlapping local models that can be combined into a global model that reduces errors and provides reliable determinations of one or more values of subsurface properties for well planning.

In some embodiments, a method for predicting a value of a subsurface property includes calculating values from a global model for subsurface properties. In some embodiments, the calculated values of the subsurface property are used to plan a well or wellbore. For example, the calculated values of the subsurface property may be used to plan a geothermal well, such as selecting a wellhead location, a quantity of wellbores, an orientation of a wellbore, a length of a wellbore, a total length of wellbores of a well, a thermal recovery capacity of the wellbores and/or well, etc. For example, the calculated values of the subsurface property may be used to plan a hydrological well, such as selecting a wellhead location, an orientation of a wellbore, a length of a wellbore, a total length of wellbores of a well, a water recovery capacity of the wellbores and/or well, etc. In some embodiments, the calculated values of the subsurface property are used to determine the feasibility of planning a geothermal well at a selected location.

In some embodiments, the method includes obtaining a plurality of geospatial datapoints. Each geospatial datapoint includes at least a location of the geospatial datapoint and a value of a subsurface property. As described herein, the subsurface property may be any continuous or discrete subsurface property. A continuous subsurface property is a property for which measured values are continuous values, such as temperature, thermal transfer rate, porosity, etc. A discrete subsurface property is a property for which a measured value defines one of a plurality of values, such as lithology (e.g., clay, sand, hard rock). In some embodiments, the subsurface property includes both a discrete component and a continuous component, such as geochemical properties in which the geochemistry identifies a mineral composition with elemental ranges for one or more components of the mineral. For example, some minerals have binary ternary replacements for some elements within the chemical structure. In such examples, a discrete value may be the mineral endmember, such as Albite for plagioclase, and a continuous value may be the sodium (relative to calcium solid solution) composition of the plagioclase.

In some embodiments, obtaining the plurality of geospatial datapoints includes obtaining geospatial datapoints from a plurality of sources and/or datasets. In some embodiments, obtaining the plurality of geospatial datapoints includes accessing public databases that may include erroneous or unverified geospatial datapoints. In such instances, the overlapping modelling areas described herein provide additional identification and verification of the location and/or values of the subsurface property of the geospatial datapoints.

The method further includes selecting a plurality of modelling areas, wherein each modelling area of the plurality of modelling areas overlaps at least a portion of a neighbouring modelling area of the plurality of modelling areas. In some embodiments, the modelling areas are the same shape. In some embodiments, at least two of the modelling areas are different shapes. For example, the modelling areas may be circular, elliptical, rectangular, triangular, pentagonal, octagonal, hexagonal, other regular polygonal shapes, regular curved shapes, irregular polygonal or curved shapes, or combinations thereof. In at least one embodiment, a modelling area is a hexagonal ring. In some embodiments, the modelling areas are the same size, irrespective of shape. For example, the modelling areas may have the same area. In other examples, the modelling areas may have an equal size in at least one dimension, such as an x-direction, a y-direction, a latitude, a longitude, a diameter, or another direction. In some embodiments, at least two of the modelling areas have a different size. In some embodiments, an overlapping region between neighbouring modelling areas is constant through the plurality of modelling areas. In some embodiments, the overlapping regions between neighbouring modelling areas varies through the plurality of modelling areas.

In some embodiments, the size and/or shape of the modelling areas is selected based at least partially on external constraints. For example, known discontinuities in the subsurface property of interest or other subsurface properties may provide one or more boundaries to a modelling area. In at least one example, a region has a known change in geologic formation and at least one modelling area is selected based on the boundary between geologic formations. In a particular example, a thermal transfer rate is known to change with lithology and a modelling area is the selected based at least partially on known lithology boundary.

The method further includes determining a local model for each modelling area based at least partially on the locations and values of the plurality of geospatial datapoints of the modelling area, wherein the local model includes a plurality of cells. The local model provides a value of the subsurface property for each location within the modelling area. In some embodiments, determining the local model includes assigning local model values for the subsurface property to the local cells based on the values of the plurality of geospatial datapoints within the modelling area. Assigning local model values may include using a statistical model or machine learning model to interpolate values between input geospatial datapoints. A statistical model may be any algorithm or other mathematical model that receives inputs to calculate values for subsurface properties.

A same location may then be part of a first local cell of a first local model associated with a first modelling area and a second local cell of a second local model associated with a second modelling area, etc. The values of the subsurface properties for the modelling area may be different depending on the local model that is applied.

In some embodiments, a first local cell of a first local model associated to a first modelling area, and a second local cell of a second local model associated to a second modelling area, etc. may have the same boundaries. The value of the subsurface property for the first local cell and second local cell may however be different based upon the determinations of the first local model and the second local model.

In some embodiments, a cell is a geographic region of a fixed area that is tiled with other cells to cover the local model or global model. For example, the cell may be a square region of the local model or global model. In some examples, the cell is a hexagonal region. In at least one example, the cell is a differential area that allows for the local model or global model to be substantially continuous across the area of the local model or global model. For example, a cell of differential area may be interpreted as a point value in the local model or global model.

As used herein, a "machine learning model" refers to a computer algorithm or model (e.g., a classification model, a regression model, a language model, an object detection model) that can be tuned (e.g., trained) based on training input to approximate unknown functions. For example, a machine learning model may refer to a neural network or other machine learning algorithm or architecture that learns and approximates complex functions and generate outputs based on a plurality of inputs provided to the machine learning model. In some embodiments, a machine learning system, model, or neural network described herein is an artificial neural network. In some embodiments, a machine learning system, model, or neural network described herein is a convolutional neural network. In some embodiments, a machine learning system, model, or neural network described herein is a recurrent neural network. In at least one embodiment, a machine learning system, model, or neural network described herein is a Bayes classifier. As used herein, a "machine learning system" may refer to one or multiple machine learning models that cooperatively generate one or more outputs based on corresponding inputs. For example, a machine learning system may refer to any system architecture having multiple discrete machine learning components that consider different kinds of information or inputs.

As used herein, an "instance" refers to an input object that may be provided as an input to a machine learning system to use in generating an output, such as a value of a subsurface property of a known geospatial datapoint. For example, an instance may refer to any known geospatial datapoint within a modelling area. In some embodiments, the machine learning system has a plurality of layers with an input layer configured to receive at least one input training dataset or input training instance and an output layer, with a plurality of additional or hidden layers therebetween. The training datasets can be input into the machine learning system to train the machine learning system and identify values of subsurface properties, associated subsurface properties, locations of discrete or continuous values for subsurface properties, or other attributes of the training instances that allow the microcontroller to identify relevant or accurate values of subsurface properties within a given modelling area. In some embodiments, the machine learning system can receive multiple training datasets concurrently and learn from the different training datasets simultaneously.

In some embodiments, the machine learning system includes a plurality of machine learning models that operate together. Each of the machine learning models has a plurality of hidden layers between the input layer and the output layer. The hidden layers have a plurality of input nodes, where each of the nodes operates on the received inputs from the previous layer. In a specific example, a first hidden layer has a plurality of nodes and each of the nodes performs an operation on each instance from the input layer. Each node of the first hidden layer provides a new input into each node of the second hidden layer, which, in turn, performs a new operation on each of those inputs. The nodes of the second hidden layer then passes outputs, such as identified clusters, to the output layer.

In some embodiments, each of the nodes has a linear function and an activation function. The linear function may attempt to optimize or approximate a solution with a line of best fit. The activation function operates as a test to check the validity of the linear function. In some embodiments, the activation function produces a binary output that determines whether the output of the linear function is passed to the next layer of the machine learning model. In this way, the machine learning system can limit and/or prevent the propagation of poor fits to the data and/or non-convergent solutions.

The machine learning model includes an input layer that receives at least one training dataset. In some embodiments, at least one machine learning model uses supervised training. In some embodiments, at least one machine learning model uses unsupervised training. Unsupervised training can be used to draw inferences and find patterns or associations from the training dataset(s) without known outputs. In some embodiments, unsupervised learning can identify clusters of similar labels or characteristics for a variety of training instances and allow the machine learning system to extrapolate the performance of instances with similar characteristics.

In some embodiments, semi-supervised learning can combine benefits from supervised learning and unsupervised learning. As described herein, the machine learning system can identify associated labels or characteristics (such as location or values for subsurface properties) between instances, which may allow a training dataset with known outputs and a second training dataset including more general input information to be fused. Unsupervised training can allow the machine learning system to cluster the instances from the second training dataset without known outputs and associate the clusters with known outputs from the first training dataset.

The method, in some embodiments, includes determining a global model for the plurality of geospatial datapoints, wherein the global model includes a plurality of global cells based on local model values of the overlapping local models. In some embodiments, the global cells are the same as the local model cells. In some embodiments, the global cells have the same shape, size, location, or combinations thereof as the local model cells. The global model includes values for the subsurface property of interest by assigning a global model value for the subsurface property to the plurality of global cells based on local model values of the local models overlapping the global cell. As will be described herein, the global model value is determined at least partially based on the local model values at the location of a global cell. In some embodiments, the global cell overlaps at least one local cell, and the global model value of the global cell is based at least partially on the local model value of the at least one local cell. For example, the global model value may be determined by selecting one of the local model values at the location of the global cell. In another example, the global model value may be determined by merging the local model values at the location of the global cell. Merging the local model values may include averaging the local model values or averaging the local model values based on a weighted average of the local model values.

The method further includes predicting at least one value of a subsurface property at a location in the global model based at least partially on the global model value of the selected global cell of the global model. For example, the global model value of the subsurface property may reflect a desired property (e.g., thermal transfer rate of a planned geothermal well), and the global model value may predict the desired property at the planned well location. In other examples, the global model value of the subsurface property may reflect an undesired property (e.g., an undesirable lithology) of a planned well or other borehole, and a planner may avoid such a location. In other examples, some anomalies within a global model may be detected and may help to discard wrong or unverified data.

As described herein, in some embodiments, the predicted values of the subsurface property are used to plan a well or wellbore. For example, the predicted values of the subsurface property may be used to plan a geothermal well, such as selecting a wellhead location, a quantity of wellbores, an orientation of a wellbore, a length of a wellbore, a total length of wellbores of a well, a thermal recovery capacity of the wellbores and/or well, etc. For example, the predicted values of the subsurface property may be used to plan a hydrological well, such as selecting a wellhead location, an orientation of a wellbore, a length of a wellbore, a total length of wellbores of a well, a water recovery capacity of the wellbores and/or well, etc.

In some embodiments, a method, according to the present disclosure, further includes selecting the local model for a modelling area from a plurality of potential local models. In such embodiments, a plurality of datasets may be used to assign values of the subsurface property to the local cells of the modelling area, each dataset including a distinct set of geospatial datapoints of the modelling area. Each of the potential local models results from the application of a predetermined statistical model to a dataset from the plurality of datasets. Selecting the local model among the plurality of local models may include a testing and/or validation of the potential local model values that are calculated by the local model.

In some embodiments, the method includes designating a first portion of the geospatial datapoints in the modelling area as training geospatial datapoints (i.e., a first set of training datapoints) and a second portion of the geospatial datapoints in the modelling area as test geospatial datapoints. In some embodiments, no less than 70% of the geospatial datapoints are training geospatial datapoints and the remaining geospatial datapoints are test geospatial datapoints. In some embodiments, no less than 80% of the geospatial datapoints are training geospatial datapoints and the remaining geospatial datapoints are test geospatial datapoints. In some embodiments, no less than 90% of the geospatial datapoints are training geospatial datapoints and the remaining geospatial datapoints are test geospatial datapoints.

The method then repeats randomly dividing the dataset of geospatial datapoints in the modelling area into training geospatial datapoints and test geospatial datapoints a predetermined number of times (e.g., creating a second set of training geospatial datapoints, a third set of geospatial datapoints, etc.) and inputting each set of training geospatial datapoints into a statistical model or machine learning model to create an associated local model based on each iteration of the training geospatial datapoints. Each local model based on each iteration of the training geospatial datapoints is scored by comparing the calculated values for locations of the test geospatial datapoints against the known values of the test geospatial datapoints for each associated potential local model. After calculating a validation score for each local model for the dataset of geospatial datapoints, the method includes selecting the local model as being the potential local model with the best validation score.

In some embodiments, inputting at least a set of training geospatial datapoints into a statistical model or machine learning model to create an associated local model based on each iteration of the training geospatial datapoints includes inputting the at least one set of training geospatial datapoints into a plurality of different statistical models or machine learning models to create an associated local model based on each of the plurality of the statistical model or machine learning models. Examples of statistical models may include kriging, such as ordinary kriging or universal kriging, using a plurality of variograms (such as gaussian or spherical), or a clustering model, etc. but any statistical or machine learning model may be used in the current disclosure. The local models produced via different training geospatial datapoints and/or different models may be scored to produce a validation score, and after producing the validation score, the method may include selecting the best local model.

In some embodiments, the validation score includes one or more of a median error value, a selected percentile error value (e.g., an 80^{th} percentile error value), a standard deviation, a nominal error value, or other validations of the quality of the model. In some embodiments, selecting the best local model includes selecting the local model with the lowest median error value. In some embodiments, the validation score is based on a weighted average or combination of one or more of the foregoing. For example, a validation score may be based on both a median error value and a standard deviation. In some examples, the validation score may be based on an equal weighting of the median error value and the standard deviation, while in other examples, the validation score may be based more heavily on the median error value than the standard deviation.

As described above, after assigning local model values to local cells using the local models, methods, according to the present disclosure, include combining the local model values in overlapping regions of neighbouring local models (and the modelling areas associated therewith) of subsurface properties where a plurality of local models overlap to build toward a global model. Combining local models and assigning values to the global cell(s) at the overlapping regions can include a variety of mechanisms.

In some embodiments, the first modelling area of the first local model and the second modelling area of the second local model overlap in an overlapping region. In some embodiments, the overlapping region includes one or more global cells that overlap local cells from each of the first local model and the second local model. In some embodiments, calculated values for local cells within the overlapping region are different for the first local model and the second local model. To combine the values of the first local model and the second local model in the global cell(s) of the overlapping region, different methods can be used and/or validated against one another.

In some embodiments, a first local model and a second local model are combined in an overlapping region by selecting and assigning global model values for the global cell(s) situated in the overlapping region. In some embodiments, combining the local model values of the overlapping region includes selecting one global model value to use for all global cells situated in the overlapping region. In some embodiments, the local model with the higher resolution (i.e., smaller modelling area size) is selected, as a higher resolution may be correlated with lower variation in the values of the datapoints therein. In some embodiments, the local model with the greater quantity of input geospatial datapoints is selected, as a local model with more input or training geospatial datapoints may be more accurate. In some embodiments, the local model with higher validation score from a prior validation is selected, as a local model with a higher validation score may be more accurate. The validation score may be calculated as described above for better local model selection for a modelling area. In some embodiments, the validation score is calculated for the local models associated to different modelling areas overlapping with the global cell(s).

In some embodiments, combining the local model values of the overlapping region includes selecting global model values for individual global cells in the overlapping region. In some embodiments, selecting global model values for individual global cells includes comparing the local model values to known values of geospatial data points in the overlapping region. For example, the first local model and second local model may share a known geospatial datapoint in the overlapping region, and the calculated local model values for each of the first local model and second local model proximate the known geospatial datapoint may be compared to the value of the known geospatial datapoint, where the closer value of the local model values is selected for the global model value.

In some embodiments, combining the local model values of the overlapping region includes merging the local model values of a first local model and the local model values of a second local model in the overlapping region. In some embodiments, merging the local model values includes averaging the local model values for each cell in the overlapping region. In some embodiments, a weighted average of local model values provides a more accurate representation of the local model values.

In some embodiments, a first local model and a second local model are combined in an overlapping region by merging values of the cells of the overlapping region by weighted averaging. In some embodiments, the weighting of the averages of the local model values is based at least partially on a proximity to a centerpoint of each local model respectively. For example, the portions of the overlapping region closer to the first centerpoint of the first local model are closer in value to the local model values of the first local model, and the portions of the overlapping region closer to the second centerpoint of the second local model are closer in value to the local model values of the second local model. In a particular example, a geospatial datapoint or cell that is equidistant from the first centerpoint and the second centerpoint receives equal weighting in averaging the value from the first local model and the second local model. In some embodiments, the weighting of the averages of the local model values is based at least partially on relative validation score of the first local model and the second local model. For example, a better validation score for the first local model may result in a weighted average that emphasizes the local model values of the first local model. In some embodiments, the weighting of the averages of the local model values is based at least partially on relative modelling area size of the first local model and the second local model. For example, a smaller modelling area size for the first local model may result in a weighted average that emphasizes the local model values of the first local model. In some embodiments, combining the local model values of the overlapping region includes selecting values for at least a first portion of the overlapping region and merging values for at least a second portion of the overlapping region.

In some embodiments, a plurality of modelling areas is selected, where the modelling areas define a plurality of overlapping regions. In some embodiments, the modelling areas have different sizes, such as the first modelling area being smaller (and higher resolution) than a second modelling area, and the second modelling area being smaller (and higher resolution) than a third modelling area. The local models are generated for the modelling areas, and values are assigned to cells in at least the overlapping regions. In the illustrated example, the values of the cells in the overlapping regions are selected from the local model with the smaller size and/or higher resolution. The global model of cells is, therefore, assigned values based local model values with the highest resolution available according to the modelling areas defined as inputs to the statistical model or machine learning model. However, any of the methods described hereinabove may be used to assign a local model value to each global cells of the global models.

While modelling areas and local models have been defined in relation to x- and y-directions, it should be understood that the geospatial datapoints and the local models created therefrom may include depth information. In some embodiments, a dataset includes a plurality of geospatial datapoints wherein at least some of the geospatial datapoints include depth information associated with the values of a subsurface property. For example, a third geospatial datapoint has a greater depth than a second geospatial datapoint, and the second geospatial datapoint has a greater depth than a first geospatial datapoint. In some embodiments, modelling areas may be selected for each range of depths. For example, values at deep measurements, such as that associated with the third geospatial datapoint may be less common than a value at a shallow measurement, such as associated with the first geospatial datapoint. A model may then be optimized by using different modelling areas at different depths. For instance, a first modelling area selected at a shallow depth associated with the first geospatial datapoint, therefore, may include more geospatial datapoints and be of higher resolution than a second modelling area selected at an intermediate depth associated with the second geospatial datapoint or a third modelling area selected at a greater depth associated with the third geospatial datapoint.

In some embodiments, global model values can be assigned to cells of depth layers of a global model in a vertical or z-direction of the global model. In such an embodiment, the combination of the local models results in a three-dimensional grid with a plurality of depth layers that assume equal values for the subsurface property at a range of depths. The local models are consolidated as described above. In some embodiments, the combination of the local models provides the same results for all the depth layers of the vertical axis.

When the geospatial datapoints include depth information, local models may be created for each depth layer based on the depth information. In some embodiments, the method uses resolutions for each depth layer and/or local model of the depth layer based at least partially on data heterogeneity of the geospatial datapoints in the z-direction. In this case, each depth layer may be calculated as described herein with the selection of modelling areas, the creation of local models, and the combination of overlapping local models. However, any combination method described hereinabove for combining local model cells may be used to assign the local model values to each global cell of the global model grid. The consolidation of the local models is performed on each depth layer, and the global model is represented as a three-dimensional grid.

In some embodiments, depth layers that each have different modelling areas based at least partially on the density of geospatial datapoints at the associated depth of the depth layer. The modelling areas and geospatial datapoints therein are used to create local models for each depth layer, which are then combined to into cells, as described herein, of discrete depth layers of the global model.

In some embodiments, the depth layers are defined by discrete boundaries between the layers, wherein the values or ranges of values in depth layers do not overlap. In some embodiments, the depth layers are defined with an overlap between the depth layers in the z-direction, as well. In overlapping the depth ranges of the depth layers, in some embodiments, the values of the subsurface properties are combined to create sublayers in the depth information.

In some embodiments, an input dataset includes values collected at multiple depths of the geospatial datapoints. In some embodiments, the dataset is divided into depth layers by overlapping depth ranges and averaging the values of the subsurface property. The values of the subsurface property measured at three depths, in some embodiments, create four depth layers including a top depth layer having subsurface property values substantially equal to the first depth, a first overlapped depth layer having subsurface property values based upon the subsurface property values measured at the first depth and the second depth, a second overlapped depth layer having subsurface property values based upon the subsurface property values measured at the second depth and the third depth, and a bottom depth layer having subsurface property values substantially equal to the third depth. In at least some embodiments, the overlapping depth layers allow for an improved resolution in the vertical direction for some datasets. In some embodiments, the sublayers can allow an input dataset to have depth layers with subsurface property values at equal depths (or substantially equal depths) to a neighboring, overlapping modelling area or local model.

The depth information of the datasets can allow for the prediction and/or visualization of a value of a subsurface property along a well trajectory. For example, the subsurface property value may be predicted and/or visualized based at least partially on local models associated with two neighboring modeling areas having equal depth ranges. In some examples, the subsurface property value may be predicted and/or visualized based at least partially on local models associated with two neighboring modeling areas having different depth ranges. In at least one embodiment, a method includes creating one or more sublayers of a first local model wherein at least one of the one or more sublayers has a depth or depth range substantially equal to a depth of the second local model.

In some embodiments, a first local model is derived from a first modelling area at a first depth range. A second local model is derived from a second modelling area at a second depth range. A well trajectory passes through local cells of both of the first local model and the second local model, and the visualization presents the predicted values along the potential well trajectory (including values associated with additional local models at additional depth ranges). In some embodiments, the visualization includes an average predicted value for the subsurface property along the potential well trajectory. In some embodiments, visualization includes a range of predicted values, such as an 80^{th} percentile range, for the subsurface property along the potential well trajectory.

In some embodiments, determining the local model and assigning a local model value for the subsurface property to local model cells is performed according to any of the methods described herein. For example, the local models may be determined, selected, and validated such as described herein. In some embodiments, depth layers of an input dataset are created such as described herein. In some embodiments, additional sublayers are created from values at different depths, such as described herein.

The present disclosure relates to systems and methods for predicting values of a subsurface property according to any of the following:

[A1] In some embodiments, a method of predicting a subsurface property value includes obtaining a plurality of geospatial datapoints and wherein each geospatial datapoint includes at least a location of the geospatial datapoint and a value of a subsurface property; selecting a plurality of modelling areas, wherein each modelling area of the plurality of modelling areas overlaps at least a portion of a neighboring modelling area of the plurality of modelling areas; determining a local model for each modelling area based at least partially on the locations and values of the plurality of geospatial datapoints located in the modelling area, wherein determining the local model includes assigning a local model value for the subsurface property to a plurality of local cells of the local model; assigning a local model value for the subsurface property to the local cells based on values of the plurality of geospatial datapoints within the modelling area; determining a global model for the plurality of geospatial datapoints, wherein the global model includes a plurality of global cells; assigning at least one global model value for the subsurface property to each global cell of the plurality of global cells based on local model values of the local models overlapping the global cell; and predicting a calculated value of the subsurface property at a selected location based at least partially on the global model value of a selected global cell of the global model.

[A2] In some embodiments, the plurality of geospatial datapoints of [A1] is obtained from a plurality of geospatial datasets, and each geospatial dataset includes a portion of the plurality of geospatial datapoints.

[A3] In some embodiments, at least one modelling area of [A1] or [A2] is selected using external constraints.

[A4] In some embodiments, the modelling areas of any of [A1] through [A3] include depth layers.

[A5] In some embodiments, the depth layers of [A4] at least partially overlap in depth.

[A6] In some embodiments, , determining a local model for a modelling area of any of [A1] through [A5] includes using at least 70% of the geospatial datapoints in the modelling area to determine the local model and remaining geospatial datapoints to validate the local model.

[A7] In some embodiments, determining a local model for a modelling area of any of [A1] through [A6] includes determining a plurality of local models for the modelling area, scoring the plurality of local models, and selecting the local model with a better score.

[A8] In some embodiments, determining a plurality of local models of [A7] includes determining a first local model based at least partially on a first training dataset and determining a second local model based at least partially on a second training dataset different from the first.

[A9] In some embodiments, determining a plurality of local models of [A7] includes determining a first local model based at least partially on a first statistical model and determining a second local model based at least partially on a second statistical model different from the first.

[A10] In some embodiments, assigning at least one global model value for the subsurface property to each global cell of the plurality of global cells based on local model values of the local models overlapping the global cell of any of [A1] through [A9] includes selecting, for at least one global cell, a local model value of the subsurface property based on at least one local model value overlapping the global cell.

[A11] In some embodiments, selecting the local model value of [A10] is based at least partially on at least one of: a modelling area size of the local models, a validation score of the local models, and a quantity of training geospatial datapoints for each of the local models.

[A12] In some embodiments, assigning at least one global model value for the subsurface property to each global cell of the plurality of global cells based on local model values of the local models overlapping the global cell of any of [A1] through [A9] includes merging, for at least one global cell, local model values of the subsurface property based on at least two local model values overlapping the global cell.

[A13] In some embodiments, merging the value of the subsurface property of [A12] is based at least partially on at least one of: a modelling area size of the local models, a validation score of the local models, and a proximity to a centerpoint of the local models.

[A14] In some embodiments, the subsurface property of any of [A1] through [A13] is a thermal transfer rate.

[A15] In some embodiments, the method of any of [A1] through [A14] includes, based at least partially on the calculated value, at least one of: selecting a wellhead location, selecting a quantity of wellbores, selecting an orientation of a wellbore, selecting a length of a wellbore, and selecting a total length of wellbores of a well.

[B1] In some embodiments, a method of predicting a subsurface property value includes obtaining a plurality of geospatial datapoints and wherein each geospatial datapoint includes at least a location of the geospatial datapoint and a value of a subsurface property; selecting a plurality of modelling areas, wherein each modelling area of the plurality of modelling areas overlaps at least a portion of a neighboring modelling area of the plurality of modelling areas; determining a local model for each modelling area based at least partially on the locations and values of the plurality of geospatial datapoints located in the modelling area, wherein determining the local model includes assigning a local model value for the subsurface property to a plurality of local cells of the local model; assigning a local model value for the subsurface property to the local cells based on values of the plurality of geospatial datapoints within the modelling area; and determining a value of the subsurface property along a potential well trajectory based on the local models associated with two modelling areas having different depth ranges.

It should be understood that references to "one embodiment" or "an embodiment" of the present disclosure are not intended to be interpreted as excluding the existence of additional embodiments that also incorporate the recited features. For example, any element described in relation to an embodiment herein may be combinable with any element of any other embodiment described herein, to the extent such features are not described as being mutually exclusive. Numbers, percentages, ratios, or other values stated herein are intended to include that value, and also other values that are "about", "substantially", or "approximately" the stated value, as would be appreciated by one of ordinary skill in the art encompassed by embodiments of the present disclosure. A stated value should therefore be interpreted broadly enough to encompass values that are at least close enough to the stated value to perform a desired function or achieve a desired result. The stated values include at least the variation to be expected in a suitable manufacturing or production process, and may include values that are within 5%, within 1%, within 0.1%, or within 0.01% of a stated value.

The terms "approximately," "about," and "substantially" as used herein represent an amount close to the stated amount that is within standard manufacturing or process tolerances, or which still performs a desired function or achieves a desired result. For example, the terms "approximately," "about," and "substantially" may refer to an amount that is within less than 5% of, within less than 1% of, within less than 0.1% of, and within less than 0.01% of a stated amount. Further, it should be understood that any directions or reference frames in the preceding description are merely relative directions or movements. For example, any references to "up" and "down" or "above" or "below" are merely descriptive of the relative position or movement of the related elements.

A person having ordinary skill in the art should realize in view of the present disclosure that equivalent constructions do not depart from the spirit and scope of the present disclosure, and that various changes, substitutions, and alterations may be made to embodiments disclosed herein without departing from the spirit and scope of the present disclosure. Equivalent constructions, including functional "means-plus-function" clauses are intended to cover the structures described herein as performing the recited function, including both structural equivalents that operate in the same manner, and equivalent structures that provide the same function. It is the express intention of the applicant not to invoke means-plus-function or other functional claiming for any claim except for those in which the words 'means for' appear together with an associated function. Each addition, deletion, and modification to the embodiments that falls within the meaning and scope of the claims is to be embraced by the claims. The described embodiments are therefore to be considered as illustrative and not restrictive, and the scope of the disclosure is indicated by the appended claims rather than by the foregoing description.

## Claims

1. A method of predicting a value of a subsurface property, the method comprising:
obtaining (412) a plurality of geospatial datapoints and wherein each geospatial datapoint includes at least a location of the geospatial datapoint and a value of a subsurface property;
selecting (414) a plurality of modelling areas, wherein each modelling area of the plurality of modelling areas overlaps at least a portion of a neighboring modelling area of the plurality of modelling areas;
determining (416) a local model for each modelling area based at least partially on the locations and values of the plurality of geospatial datapoints located in the modelling area, wherein determining the local model includes assigning a local model value for the subsurface property to a plurality of local cells of the local model based on values of the plurality of geospatial datapoints within the modelling area;
determining (420) a global model for the plurality of geospatial datapoints, wherein the global model includes a plurality of global cells;
assigning (422) at least one global model value for the subsurface property to each global cell of the plurality of global cells based on local model values of the local models overlapping the global cell; and
predicting (424) a calculated value of the subsurface property at a selected location based at least partially on the global model value of a selected global cell of the global model.

2. The method of claim 1, wherein the plurality of geospatial datapoints is obtained from a plurality of geospatial datasets, wherein each geospatial dataset includes a portion of the plurality of geospatial datapoints.

3. The method of any of claims 1or 2, wherein at least one modelling area is selected using external constraints.

4. The method of any preceding claim, wherein the modelling areas include depth layers (942-1, 942-2, 942-3).

5. The method of claim 4, wherein the depth layers (1142-2) at least partially overlap in depth.

6. The method of any preceding claim, wherein determining a local model for a modelling area includes using at least 70% of the geospatial datapoints (502-1) in the modelling area to determine the local model and remaining geospatial datapoints (502-2) to validate the local model.

7. The method of any preceding claim, wherein determining a local model for a modelling area includes:
determining (526) a plurality of local models for the modelling area,
scoring (528) the plurality of local models, and
selecting (530) a local model with a better score.

8. The method of claim 7, wherein determining a plurality of local models includes determining a first local model based at least partially on a first training dataset and determining a second local model based at least partially on a second training dataset different from the first training dataset.

9. The method of claim 7, wherein determining a plurality of local models includes determining a first local model based at least partially on a first statistical model and determining a second local model based at least partially on a second statistical model different from the first statistical model.

10. The method of any preceding claim, wherein assigning (422) at least one global model value for the subsurface property to each global cell of the plurality of global cells based on local model values of the local models overlapping the global cell includes selecting, for at least one global cell, a local model value of the subsurface property based on at least one local model value overlapping the global cell.

11. The method of claim 10, wherein selecting the local model value is based at least partially on at least one of: a modelling area size of the local models (632-1, 632-2), a validation score of the local models (632-1, 632-2), and a quantity of training geospatial datapoints (502-1) for each of the local models (632-1, 632-2).

12. The method of any of claims 1-9, wherein assigning (422) at least one global model value for the subsurface property to each global cell of the plurality of global cells based on local model values of the local models overlapping the global cell includes merging, for at least one global cell, local model values of the subsurface property based on at least two local model values overlapping the global cell (632-1, 632-2).

13. The method of claim 12, wherein merging the value of the subsurface property is based at least partially on at least one of: a modelling area size of the local models (632-1, 632-2), a validation score of the local models (632-1, 632-2), and a proximity to a centerpoint (636-1, 636-2) of the local models (632-1, 632-2).

14. The method of any preceding claim, wherein the subsurface property is a thermal transfer rate.

15. The method of any preceding claim, further comprising, based at least partially on the calculated value, at least one of: selecting a wellhead location, selecting a quantity of wellbores, selecting an orientation of a wellbore, selecting a length of a wellbore, and selecting a total length of wellbores of a well.

16. A method of determining a subsurface property, the method comprising:
obtaining a plurality of geospatial datapoints and wherein each geospatial datapoint includes at least a location of the geospatial datapoint and a value of a subsurface property;
selecting a plurality of modelling areas, wherein each modelling area of the plurality of modelling areas overlaps at least a portion of a neighboring modelling area of the plurality of modelling areas and have a depth range, each modelling area including subsurface property values associated with one or more locations in the modelling area;
determining a local model for each modelling area based at least partially on the locations and values of the plurality of geospatial datapoints, wherein determining the local model includes assigning a local model value for the subsurface property to a plurality of local cells of the local model based on values of the plurality of geospatial datapoints within the modelling area, wherein each local cell has a location and depth;
determining a value of the subsurface property along a potential well trajectory (1346) based on the local models associated with at least two modelling areas having different depth ranges.
